# EUROPÄISCHE PATENTSCHRIFT

(11) **EP 4 519 915 B1**
(45) Veröffentlichungstag und Bekanntmachung des Hinweises auf die Patenterteilung: **11.03.2026**
(21) Anmeldenummer: 23753857.4
(22) Anmeldetag: 02.08.2023
(51) Int. Cl.: H01L 23/373, H01L 21/48, H01L 25/07, H01L 23/367, H01L 23/467

(54) **VERFAHREN ZUR HERSTELLUNG EINES HALBLEITERMODULS MIT MINDESTENS EINER HALBLEITERANORDNUNG UND EINEM KÜHLKÖRPER**
METHOD FOR PRODUCING A SEMICONDUCTOR MODULE HAVING AT LEAST ONE SEMICONDUCTOR ARRANGEMENT AND A HEATSINK
PROCÉDÉ DE FABRICATION D'UN MODULE SEMI-CONDUCTEUR COMPRENANT AU MOINS UN ENSEMBLE SEMI-CONDUCTEUR ET UN DISSIPATEUR THERMIQUE

(30) Priorität: 02.08.2022 EP 22188328; 28.09.2022 EP 22198444
(43) Veröffentlichungstag der Anmeldung: 12.03.2025
(73) Patentinhaber: Siemens Aktiengesellschaft, 80333 München (DE)
(72) Erfinder: NÄHRIG, Matthias, 91334 Hemhofen (DE); KÖGLER, Roman, 90403 Nürnberg (DE); KAPPAUF, Daniel, 91322 Gräfenberg (DE); SCHMENGER, Jens, 91301 Forchheim (DE); PFEFFERLEIN, Stefan, 90562 Heroldsberg (DE)
(74) Vertreter: Siemens Patent Attorneys
(86) Internationale Anmeldenummer: PCT/EP2023/071411
(87) Internationale Veröffentlichungsnummer: WO 2024/028389

(56) Entgegenhaltungen:
- EP-A1- 3 940 769
- WO-A1-2015/019890

## Beschreibung

Die Erfindung betrifft ein Verfahren zur Herstellung eines Halbleitermoduls mit mindestens einer Halbleiteranordnung und einem Kühlkörper umfassend folgende Schritte: Bereitstellen eines Kühlkörpers, der aus einem ersten metallischen Werkstoff hergestellt ist, Einbringen einer Kavität in eine Kühlkörper-Oberfläche, wobei die Kavität eine, insbesondere parallel zur Kühlkörper-Oberfläche verlaufende, Grundfläche und zumindest einen Wandabschnitt aufweist, Aufbringen eines zweiten metallischen Werkstoffs, der eine höhere Wärmeleitfähigkeit als der erste metallische Werkstoff aufweist, in der Kavität mittels eines thermischen Spritzverfahrens zur Ausbildung einer Wärmespreiz-Lage, Verbinden der Halbleiteranordnung mit der Wärmespreiz-Lage.

Ferner betrifft die Erfindung ein Halbleitermodul mit mindestens einer Halbleiteranordnung und einem Kühlkörper, welcher aus einem ersten metallischen Werkstoff hergestellt ist und mindestens eine Kavität umfasst, die eine, insbesondere parallel zur Kühlkörper-Oberfläche verlaufende, Grundfläche und zumindest einen Wandabschnitt aufweist, wobei in der Kavität ein zweiter metallischer Werkstoff, der eine höhere Wärmeleitfähigkeit als der erste metallische Werkstoff aufweist, mittels eines thermischen Spritzverfahrens zur Ausbildung einer Wärmespreiz-Lage aufgebracht ist, wobei die Halbleiteranordnung mit der Wärmespreiz-Lage verbunden ist,
Überdies betrifft die Erfindung einen Stromrichter mit mindestens einem derartigen Halbleitermodul.

Darüber hinaus betrifft die Erfindung ein Computerprogrammprodukt, umfassend Befehle, die bei einer Ausführung des Programms durch einen Computer diesen veranlassen, ein, insbesondere thermisches und/oder elektrisches, Verhalten eines derartigen Halbleitermoduls zu simulieren.

In derartigen Stromrichtern werden in der Regel Halbleiteranordnungen auf einen Kühlkörper befestigt. Unter einem Stromrichter ist beispielsweise ein Gleichrichter, ein Wechselrichter, ein Umrichter oder ein Gleichspannungswandler zu verstehen. Üblicherweise sind die Halbleiteranordnungen als Elektronikmodule ausgeführt, die ein Gehäuse aufweisen und über eine massive metallische Bodenplatte auf den Kühlkörper aufgeschraubt sind. Ferner können die Halbleiteranordnungen unmittelbar, das heißt ohne ein zusätzliches Verbindungselement wie eine Grundplatte, mit dem Kühlkörper verbunden werden. Die Halbleiteranordnungen können unter anderem Transistoren, insbesondere Insulated-Gate-BipolarTransistoren (IGBTs) und/oder Metall-Oxid-Halbleiter-Feldeffekttransistoren (MOSFETs), umfassen.

Die Offenlegungsschrift WO 2011/024377 A1 beschreibt ein Halbleitermodul mit einem Wärmestrahlungselement mit einem ersten Element, das Aluminium enthält, und ein zweites Element, das Kupfer enthält, das in das erste Element eingebettet ist und dessen Seiten von dem ersten Element umschlossen sind; und ein Halbleiterelement, das thermisch mit dem Wärmestrahlungselement verbunden ist.

Die Offenlegungsschrift WO 2022/002464 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind. Der Kühlkörper ist aus einem ersten metallischen Werkstoff hergestellt. Auf seiner Oberfläche sind Kavitäten eingebracht, die mit einem zweiten metallischen Werkstoff gefüllt sind, wobei der zweite metallische Werkstoff eine höhere Wärmeleitfähigkeit als der erste metallische Werkstoff aufweist. Der zweite metallische Werkstoff wird mittels eines additiven Verfahrens, beispielsweise mittels Kaltgasspritzen, in die Kavitäten eingebracht. Weitere Offenlegungsschriften, die Verfahren zur Herstellung eines Halbleitermoduls darstellen, sind WO 2015/019890 A1 und EP 3 940 769 A1.

Ein Aufbringen des zweiten metallischen Werkstoffs durch ein additives Verfahren bringt Herausforderungen hinsichtlich der thermischen Kontaktierung in der Kavität mit sich. Vor diesem Hintergrund ist es eine Aufgabe der vorliegenden Erfindung, eine thermische Kontaktierung des zweiten metallischen Werkstoffs in der Kavität zu verbessern.

Diese Aufgabe wird erfindungsgemäß bei einem Verfahren der eingangs genannten Art dadurch gelöst, dass beim Einbringen der Kavität jeweils ein stumpfer Winkel zwischen der Grundfläche und dem zumindest einen Wandabschnitt ausgebildet wird.

Ferner wird die Aufgabe erfindungsgemäß durch ein Halbleitermodul der eingangs genannten Art dadurch gelöst, dass ein stumpfer Winkel zwischen der Grundfläche und dem zumindest einen Wandabschnitt ausgebildet ist.

Überdies wird die Aufgabe erfindungsgemäß durch einen Stromrichter mit mindestens einem derartigen Halbleitermodul gelöst.

Darüber hinaus wird die Aufgabe erfindungsgemäß durch ein Computerprogrammprodukt, umfassend Befehle, die bei einer Ausführung des Programms durch einen Computer diesen veranlassen, ein, insbesondere thermisches und/oder elektrisches, Verhalten eines derartigen Halbleitermoduls zu simulieren, gelöst.

Die in Bezug auf das Verfahren nachstehend angeführten Vorteile und bevorzugten Ausgestaltungen lassen sich sinngemäß auf das Halbleitermodul, den Stromrichter und das Computerprogrammprodukt übertragen.

Der Erfindung liegt die Überlegung zugrunde, die thermische Anbindung von Wärmespreiz-Lagen in Kavitäten eines Kühlkörpers für ein Halbleitermodul, welche mittels eines thermischen Spritzverfahrens aufgebracht werden, durch Verbesserung der Haftung der aufgebrachten Partikel zu verbessern. Zur Herstellung derartiger Wärmespreiz-Lagen wird eine Kavität in eine Kühlkörper-Oberfläche eingebracht, wobei die Kavität eine, insbesondere parallel zur Kühlkörper-Oberfläche verlaufende, Grundfläche und zumindest einen Wandabschnitt aufweist. Beispielsweise ist die Grundfläche rechteckig oder quadratisch ausgeführt und die Kavität weist vier Wandabschnitte auf. Alternativ kann die Kavität eine elliptische oder kreisförmige Grundfläche mit einem umlaufenden Wandabschnitt aufweisen. Das Einbringen der Kavität kann beispielsweise mittels eines spanenden Verfahrens, insbesondere Fräsen, erfolgen. In einem weiteren Schritt wird ein zweiter metallischer Werkstoff, der eine höhere Wärmeleitfähigkeit als der erste metallische Werkstoff des Kühlkörpers aufweist, auf die Grundfläche und den zumindest einen Wandabschnitt der Kavität mittels eines thermischen Spritzverfahrens aufgebracht, wodurch die Wärmespreiz-Lage in der Kavität ausgebildet wird. Beispielsweise ist der erste metallische Werkstoff eine Aluminiumlegierung, während der zweite metallische Werkstoff Kupfer oder eine Kupferlegierung enthält. Ein Beispiel für ein thermisches Spritzverfahren ist unter anderem Kaltgasspritzen, wobei Partikel des zweiten metallischen Werkstoffs, insbesondere Kupferpartikel, aufgesprüht werden, wodurch eine stoffschlüssige Verbindung ausgebildet wird. Durch ein Verbinden der Halbleiteranordnung mit der Wärmespreiz-Lage wird durch Wärmespreizung eine optimierte Entwärmung während eines Betriebes des Halbleitermoduls erreicht.

Beim Einbringen der Kavität wird jeweils ein stumpfer Winkel zwischen der Grundfläche und dem zumindest einen Wandabschnitt ausgebildet, wobei ein stumpfer Winkel in diesem Zusammenhang als ein Winkel zwischen 95° und 175° definiert wird. Folglich resultiert daraus, dass der zumindest eine Wandabschnitt, insbesondere bei einer parallel zur Kühlkörper-Oberfläche verlaufenden Grundfläche, einen spitzen Winkel im Bereich von 5° bis 85° zur Kühlkörper-Oberfläche ausbildet, sodass die Kavitäten eine im Wesentlichen trapezförmige Querschnittsfläche aufweisen. Durch einen derartigen Winkel wird unter anderem eine Oberflächenvergrößerung erreicht, was sich positiv auf die Haftung des zweiten metallischen Werkstoffs in den Kavitäten auswirkt. Die Oberflächenvergrößerung ist darüber hinaus zweckmäßig beim Wärmeübertrag in den Kühlkörper. Ferner trifft ein Spritzpartikelstrahl des thermischen Spritzverfahrens in einem günstigeren Winkel auf, sodass eine stärkere Haftung und damit eine verbesserte thermische Kontaktierung des zweiten metallischen Werkstoffs in der Kavität erzielt wird.

Ein Computerprogrammprodukt, welches Befehle umfasst, die bei einer Ausführung des Programms durch einen Computer diesen veranlassen, ein, insbesondere thermisches und oder elektrisches, Verhalten des beschriebenen Halbleitermoduls zu simulieren kann einen "digitalen Zwilling", auch "digital twin" genannt, umfassen oder als ein solcher ausgebildet sein. Ein derartiger digitaler Zwilling ist beispielsweise in der Offenlegungsschrift US 2017/0286572 A1 dargestellt. Der "digitale Zwilling" ist beispielsweise eine digitale Repräsentanz der für den Betrieb des Halbleitermoduls relevanten Komponenten.

In die Grundfläche der Kavität wird zumindest eine zusätzliche Vertiefung eingebracht, welche kleiner als die Grundfläche der Kavität ist, wobei das Aufbringen des zweiten metallischen Werkstoffs mittels des thermischen Spritzverfahrens in der Kavität und der zumindest einen zusätzlichen Vertiefung erfolgt, sodass eine Wärmespreiz-Lage ausgebildet wird, welche unterschiedliche Dicken aufweist. Die zumindest eine zusätzliche Vertiefung kann eine rechteckige oder quadratische Grundfläche aufweisen. Beispielsweise ist zwischen einer Grundfläche und einem Wandabschnitt der Vertiefung ein stumpfer Winkel ausgebildet, der dem stumpfen Winkel der Kavität entsprechen oder sich von diesem unterscheiden kann. Durch den stumpfen Winkel weisen die zusätzlichen Vertiefungen ebenfalls einen im Wesentlichen trapezförmigen Querschnitt auf. Eine mit dem zweiten metallischen Werkstoff gefüllte zusätzliche Vertiefung sorgt für eine lokale Verdickung der Wärmespreiz-Lage, was die thermische Anbindung der Halbleiteranordnung, beispielsweise bei auftretenden Hotspots, verbessert.

Eine weitere Ausführungsform sieht vor, dass der stumpfe Winkel zwischen der Grundfläche und dem zumindest einen Wandabschnitt im Bereich von 95° bis 150°, insbesondere 110° bis 150°, ferner insbesondere 130° bis 150°, liegt. Durch einen derartigen Winkel wird eine optimierte Haftung und damit eine verbesserte thermische Kontaktierung des zweiten metallischen Werkstoffs in den Kavitäten erzielt.

Eine weitere Ausführungsform sieht vor, dass das Aufbringen des zweiten metallischen Werkstoffs unter einem Spritzwinkel des thermischen Spritzverfahrens im Bereich von 60° bis 90°, insbesondere von 70° bis 90°, erfolgt. Beispielsweise werden Partikel des zweiten metallischen Werkstoffs mittels einer Spritzvorrichtung, welche insbesondere eine Spritzpistole umfasst, in einem Spritzstrahl, der auch als Spritzpartikelstrahl bezeichnet werden kann, aufgebracht, wobei der Spritzstrahl in einem Spritzwinkel auftrifft. Ein Spritzwinkel im Bereich von 60° bis 90° sorgt dafür, dass ein Abprallen von Partikel beim thermischen Spritzverfahren minimiert wird und die Partikel definiert auf dem Trägermaterial aufgebracht werden können. Zusätzlich zum stumpfen Winkel zwischen der Grundfläche und dem zumindest einen Wandabschnitt kann ein, insbesondere dynamisches bzw. positionsabhängiges, Neigen der Spritzvorrichtung eine Einstellung eines derartigen Spritzwinkels auch im Bereich des mindestens einen Wandabschnitts ermöglichen.

Eine weitere Ausführungsform sieht vor, dass nach dem Aufbringen des zweiten metallischen Werkstoffs ein Planfräsen der Kühlkörper-Oberfläche erfolgt. Auf diese Weise wird eine ebene Oberfläche der Wärmespreiz-Lage hergestellt und ein planbündiger Abschluss der Wärmespreiz-Lage mit der Kühlkörper-Oberfläche erzielt, sodass z.B. ein ebenes Substrat der Halbleiteranordnung einfach, platzsparend und mit einem geringen thermischen Widerstand mit der Wärmespreiz-Lage verbindbar ist.

Eine weitere Ausführungsform sieht vor, dass beim Einbringen der Kavität zwischen der Grundfläche und zumindest einem Wandabschnitt und/oder zwischen zumindest zwei Wandabschnitten eine konkav gewölbte Formoberfläche ausgebildet wird. Eine derartige konkav gewölbte Formoberfläche ist beispielsweise durch ein spanendes Verfahren, insbesondere mittels eines rotierenden Fräsers, herstellbar und führt zu einer Oberflächenvergrößerung im Verbindungsbereich zwischen der Grundfläche zumindest einem Wandabschnitt bzw. zwischen zumindest zwei Wandabschnitten, wodurch die Haftung und damit die thermische Kontaktierung des zweiten metallischen Werkstoffs in der Kavität verbessert wird.

Eine weitere Ausführungsform sieht vor, dass die Halbleiteranordnung mindestens ein Halbleiterelement und ein Substrat umfasst, wobei das Substrat der Halbleiteranordnung flächig mit der Wärmespreiz-Lage verbunden wird. Ein Substrat ist unter anderem eine beidseitig metallisierte dielektrische Materiallage. Das Substrat kann beispielsweise als DCB (Direct Copper Bonded) Substrat ausgeführt sein, wobei die dielektrische Materiallage Aluminiumoxid oder Aluminiumnitrid enthalten kann. Das mindestens eine Halbleiterelement kann unter anderem einen, insbesondere vertikaler, Transistor und/oder eine Diode, aufweisen. Der, insbesondere vertikale, Transistor kann unter anderem als ein Insulated-Gate-BipolarTransistor (IGBT) ausgeführt sein. Über eine flächige Anbindung an die Wärmespreiz-Lage wird eine gute thermische Anbindung des mindestens einen Halbleiterelements erreicht.

Eine weitere Ausführungsform sieht vor, dass das Substrat der Halbleiteranordnung unmittelbar stoffschlüssig mit der Wärmespreiz-Lage verbunden wird. Die unmittelbar stoffschlüssige Verbindung zur Wärmespreiz-Lage des Kühlkörpers kann unter anderem durch Löten, Sintern oder adhäsiv hergestellt werden. Unter einer unmittelbar stoffschlüssigen Verbindung ist eine direkte Verbindung zu verstehen, die Verbindungsmittel zur Herstellung der stoffschlüssigen Verbindung wie Kleber, Lötzinn, Sinterpaste, ... einschließt, zusätzliche Verbindungselemente wie einen zusätzlichen Leiter, einen Abstandshalter, eine Bodenplatte, Wärmeleitpaste, ... jedoch ausschließt. Durch den Wegfall derartiger zusätzlicher Verbindungselemente wird eine verbesserte thermische Anbindung des mindestens einen Halbleiterelements erreicht, sodass eine verbesserte Entwärmung stattfindet. Darüber hinaus wird durch die unmittelbar stoffschlüssige Verbindung Bauraum eingespart.

Eine weitere Ausführungsform sieht vor, dass eine Oberfläche der Wärmespreiz-Lage im Wesentlichen einer Fläche des Substrats entspricht, wobei das Substrat der Halbleiteranordnung vollflächig mit der Wärmespreiz-Lage verbunden wird. Beispielsweise schließt die Wärmespreiz-Lage im Wesentlichen bündig mit dem Substrat ab. Eine derartige gezielte Anordnung der Wärmespreiz-Lage ist kosteneffizient und es wird eine optimierte thermische Anbindung der Halbleiteranordnung erreicht.

Eine weitere Ausführungsform sieht vor, dass die zumindest eine zusätzliche Vertiefung innerhalb einer senkrechten Projektionsfläche mindestens eines Halbleiterelements angeordnet wird. Beispielsweise kann eine zusätzliche Vertiefung eine Grundfläche aufweisen, die an eine Grundfläche oder an einen Footprint eines Halbleiterelements angepasst ist. Eine derartige unterhalb mindestens eines Halbleiterelements angeordnete und mit dem zweiten metallischen Werkstoff gefüllte zusätzliche Vertiefung sorgt für eine lokale Verdickung der Wärmespreiz-Lage, was die thermische Anbindung des Halbleiterelements der Halbleiteranordnung verbessert.

Im Folgenden wird die Erfindung anhand der in den Figuren dargestellten Ausführungsbeispiele näher beschrieben und erläutert.

Es zeigen:
- FIG 1: eine schematische dreidimensionale Schnittdarstellung eines Kühlkörpers für ein Halbleitermodul,
- FIG 2: eine schematische dreidimensionale Darstellung eines thermischen Spritzverfahrens,
- FIG 3: eine schematische Querschnittsdarstellung einer ersten Ausführungsform eines Halbleitermoduls,
- FIG 4: eine vergrößerte schematische Querschnittsdarstellung einer ersten Ausführungsform eines Halbleitermoduls,
- FIG 5: eine vergrößerte schematische Querschnittsdarstellung einer zweiten Ausführungsform eines Halbleitermoduls,
- FIG 6: ein Ablaufdiagramm eines Verfahrens zur Herstellung eines Halbleitermoduls,
- FIG 7: eine schematische dreidimensionale Schnittdarstellung einer dritten Ausführungsform eines Halbleitermoduls,
- FIG 8: eine schematische dreidimensionale Schnittdarstellung einer vierten Ausführungsform eines Halbleitermoduls und
- FIG 9: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

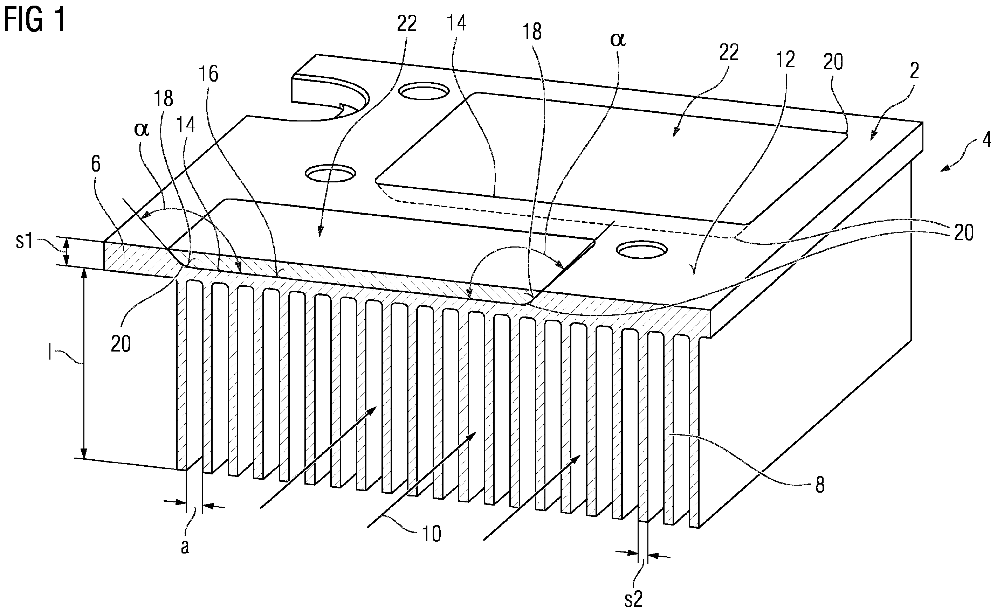

FIG 1 zeigt eine schematische dreidimensionale Schnittdarstellung eines Kühlkörpers 2 für ein Halbleitermodul 4. Der Kühlkörper weist eine Grundplatte 6 mit Kühlrippen 8 auf, wobei die Kühlrippen 8 mit der Grundplatte 6 verbunden sind. Beispielhaft sind in FIG 1 die Grundplatte 6 und die Kühlrippen 8 des Kühlkörpers 2 einstückig ausgeführt. Der Kühlkörper 2 ist durch die Kühlrippen 8 konfiguriert, ein, insbesondere gasförmiges, Kühlfluid in eine Kühlmittelströmungsrichtung 10 zu leiten, wobei die Kühlmittelströmungsrichtung 10 im Wesentlichen parallel zu einer ebenen Kühlkörper-Oberfläche 12 verläuft. Das Kühlfluid ist beispielsweise Luft, die über einen Lüfter, der aus Gründen der Übersichtlichkeit in FIG 1 nicht dargestellt ist, in die Kühlmittelströmungsrichtung 10 über die Kühlrippen 8 des Kühlkörpers 2 strömt. Die Grundplatte 6 weist eine im Wesentlichen konstante erste Stärke s1 von 3,5 mm bis 5 mm, insbesondere 3,5 mm bis 4 mm, auf, während die Kühlrippen 8 eine zweite Stärke s2 aufweisen, welche kleiner als die erste Stärke s1 der Grundplatte 6 ist.

Der Kühlkörper 2 ist aus einem ersten metallischen Werkstoff hergestellt. Der erste metallische Werkstoff kann unter anderem eine Aluminiumlegierung sein, welche beispielsweise einen Siliziumanteil von 0,1 % bis 1,0 %, insbesondere von 0,1 % bis 0,6 % enthält. Ein derartiger Kühlkörper 2 kann unter anderem mittels Strangpressen hergestellt werden. Ferner sind die Kühlrippen 8 des aus der Aluminiumlegierung hergestellten Kühlkörpers 2 derartig angeordnet, dass ein Verhältnis einer Länge 1 der Kühlrippen 8 zu einem Abstand a zwischen den Kühlrippen 8 mindestens 10 beträgt: 1/a≥10.

Darüber hinaus weist der Kühlkörper 2 beispielhaft zwei in der Grundplatte 6 angeordnete Kavitäten 14 auf, welche eine parallel zur Kühlkörper-Oberfläche 12 verlaufende, insbesondere im Wesentlichen ebene, Grundfläche 16 und Wandabschnitte 18 aufweisen. Die Grundfläche 16 ist beispielhaft rechteckig ausgeführt. Zwischen der Grundfläche 16 und dem Wandabschnitten 18 wird ein stumpfer Winkel α ausgebildet, der beispielhaft bei 140° liegt, sodass die Kavitäten 14 eine im Wesentlichen trapezförmige Querschnittsfläche aufweisen. Alternativ kann der Winkel α zwischen der Grundfläche 16 und dem Wandabschnitten 18 im Bereich von 95° bis 150°, insbesondere 110° bis 150°, ferner insbesondere 130° bis 150°, liegen. Das Einbringen der Kavitäten 14 kann beispielsweise mittels eines spanenden Verfahrens, beispielsweise Fräsen, erfolgen. Zwischen der Grundfläche 16 und den Wandabschnitten 18 sowie zwischen benachbarten Wandabschnitten 18 ist eine konkav gewölbte Formoberfläche 20 ausgebildet.

In den Kavitäten 14 ist ein zweiter metallischer Werkstoff angeordnet, der eine höhere Wärmeleitfähigkeit als der erste metallische Werkstoff aufweist. Beispielsweise enthält der zweite metallische Werkstoff Kupfer oder eine Kupferlegierung. Der zweite metallische Werkstoff ist mittels eines thermischen Spritzverfahrens, beispielsweise mittels Kaltgasspritzen, zur Ausbildung einer Wärmespreiz-Lage 22 aufgebracht, wobei zweite metallische Werkstoff durch das thermische Spritzverfahren stoffschlüssig mit dem ersten Werkstoff verbunden wird. Darüber hinaus schließt der zweite metallische Werkstoff der in den Kavitäten 14 angeordneten Wärmespreiz-Lagen 22 im Wesentlichen planbündig mit der Kühlkörper-Oberfläche 12 ab, sodass eine ebene Oberfläche ausbildet wird. Ein derartiger planbündiger Abschluss ist beispielsweise durch Planfräsen herstellbar. Durch den stumpfen Winkel α zwischen der Grundfläche 16 und dem Wandabschnitten 18 treffen Partikel des zweiten metallischen Werkstoffs beim thermischen Spritzverfahren in einem günstigeren Winkel auf, sodass eine stärkere Haftung und damit eine verbesserte thermische Kontaktierung des zweiten metallischen Werkstoffs in den Kavitäten 14 erzielt wird. Auch die konkav gewölbten Formoberflächen 20 zwischen der Grundfläche 16 und den Wandabschnitten 18 sowie zwischen den benachbarten Wandabschnitten 18 ermöglichen einen günstigeren Spritzwinkel und damit eine verbesserte thermische Kontaktierung.

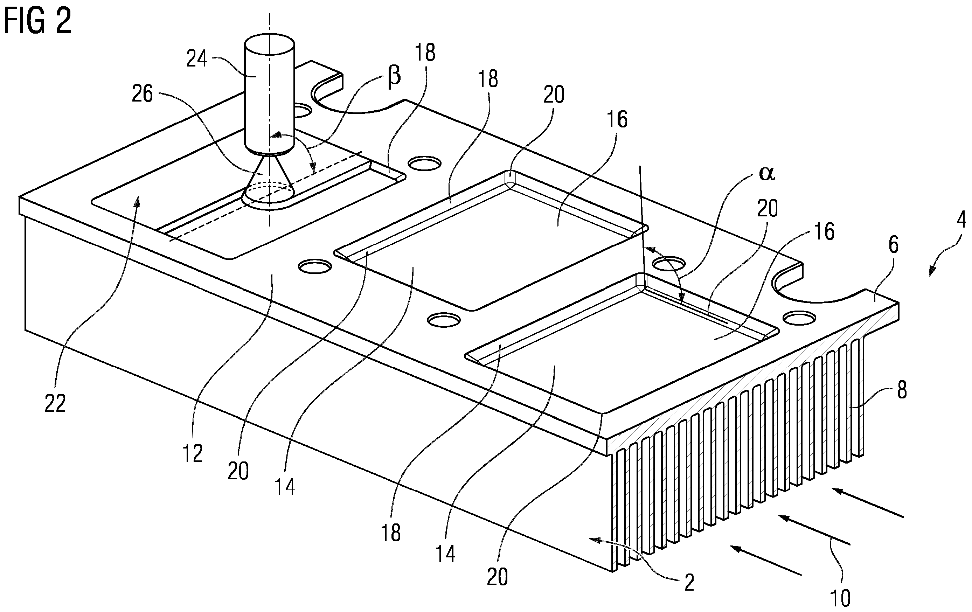

FIG 2 zeigt eine schematische dreidimensionale Darstellung eines thermischen Spritzverfahrens. Beispielhaft ist in FIG 2 ein Aufbringen des zweiten metallischen Werkstoffs mittels Kaltgasspritzens dargestellt. Der zweite metallische Werkstoff wird durch eine Spritzvorrichtung 24, welche beispielsweise eine Spritzpistole umfasst, in einem Spritzstrahl 26, der auch als Spritzpartikelstrahl bezeichnet werden kann, aufgebracht. Der Spritzvorgang erfolgt unter einem Spritzwinkel β im Bereich von 60° bis 90°, insbesondere von 70° bis 90°. Neben dem stumpfen Winkel α zwischen der Grundfläche 16 und den Wandabschnitten 18 führt ein dynamisches bzw. positionsabhängiges Neigen der Spritzvorrichtung 24 zu einer Optimierung des Spritzwinkels β auch im Bereich der Wandabschnitte 18. Die weitere Ausführung des Kühlkörpers 2 in FIG 2 entspricht der Ausführung in FIG 1.

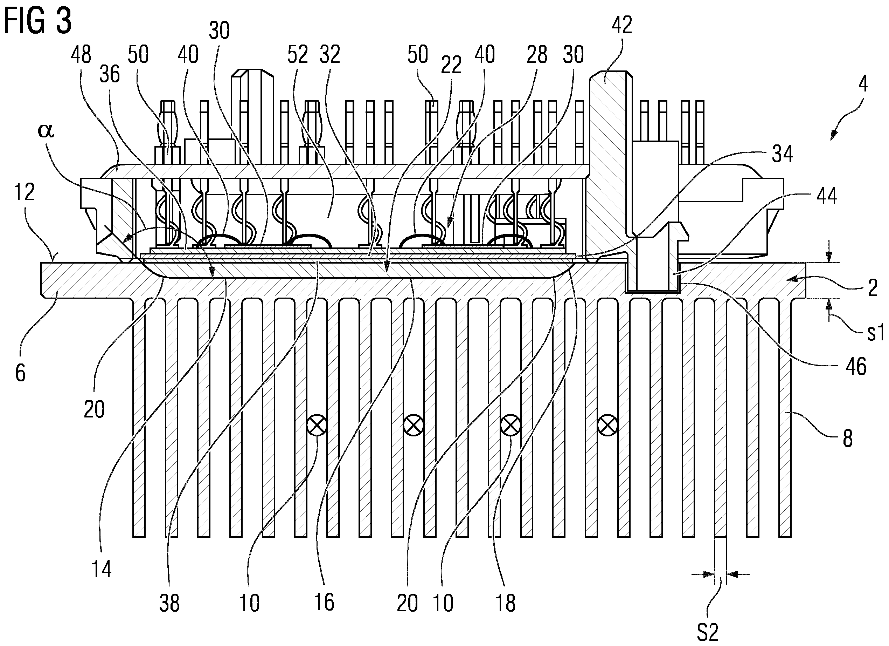

FIG 3 zeigt eine schematische dreidimensionale Schnittdarstellung einer ersten Ausführungsform eines Halbleitermoduls 4, welches neben dem Kühlkörper 2 eine Halbleiteranordnung 28 umfasst. Die Halbleiteranordnung 28 weist Halbleiterelemente 30 auf, welche als, insbesondere vertikaler, Transistor oder als Diode ausgeführt sind. Ein Transistor kann unter anderem als Insulated-Gate-BipolarTransistor (IGBT), als Metalloxide-Semiconductor-Field-Effect-Transistor (MOSFET) oder als Bipolartransistor ausgeführt sein. Einem Transistor kann eine, insbesondere antiparalelle, Diode zugewiesen sein. Die Halbleiterelemente 30 sind stoffschlüssig mit einem Substrat 32 verbunden, wobei die stoffschlüssige Verbindung unter anderem durch Löten und/oder Sintern herstellbar ist.

Das Substrat 32 weist eine dielektrische Materiallage 34 auf, die einen keramischen Werkstoff, beispielsweise Aluminiumnitrid oder Aluminiumoxid, oder einen organischen Werkstoff, beispielsweise einem Polyamid enthält. Die dielektrische Materiallage 34 kann eine Dicke von 25 µm bis 400 µm, insbesondere 50 µm bis 250 µm, aufweisen. Darüber hinaus weist das Substrat 32 auf einer den Halbleiterelementen 30 zugewandten Seite eine strukturierte erste Metallisierung 36 und auf einer den Halbleiterelementen 30 abgewandten Seite eine zweite Metallisierung 38 auf. Das Substrat 32 der Halbleiteranordnung 28 ist über die zweite Metallisierung 38 vollflächig und unmittelbar stoffschlüssig mit der Wärmespreiz-Lage 22 des Kühlkörpers 2 verbunden. Darüber hinaus ist die Kavität 14 derartig ausgeführt, dass die Wärmespreiz-Lage 22 im Wesentlichen bündig mit dem Substrat 32 abschließt. Die stoffschlüssige Verbindung zum Kühlkörper 2 wird durch Löten oder Sintern hergestellt. Die unmittelbar stoffschlüssige Verbindung zur Wärmespreiz-Lage 22 des Kühlkörpers 2 kann unter anderem durch Löten, Sintern oder adhäsiv hergestellt werden. Unter einer unmittelbar stoffschlüssigen Verbindung ist eine direkte Verbindung zu verstehen, die Verbindungsmittel zur Herstellung der stoffschlüssigen Verbindung wie Kleber, Lötzinn, Sinterpaste, ... einschließt, zusätzliche Verbindungselemente wie einen zusätzlichen Leiter, einen Abstandshalter, eine Bodenplatte, Wärmeleitpaste, ... jedoch ausschließt. Die Halbleiterelemente 30 sind auf einer dem Substrat 32 abgewandten Seite über Verdrahtungselemente 40 mit der ersten Metallisierung 36 des Substrats 32 verbunden. Die Verdrahtungselemente 40 können unter anderem mindestens einen Bonddraht und/oder mindestens einen Ribbon-Bond umfassen.

Die Halbleiteranordnung 28 ist in einem Gehäuse 42 angeordnet, welches beispielsweise aus einem Kunststoff hergestellt ist. Das Gehäuse 42 ist über eine formschlüssige Verbindung 44 mit einem Sackloch 46 auf dem Kühlkörper 2 angeordnet. Durch einen Gehäusedeckel 48 verlaufende frei positionierbare Kontakte 50 sind stoffschlüssig, z.B. durch Löten oder Sintern, mit der ersten Metallisierung 36 des Substrats 32 verbunden. Die Halbleiteranordnung 28 ist innerhalb des Gehäuses 42 mit einer Vergussmasse 52 vergossen. Die weitere Ausführung des Kühlkörpers 2 in FIG 3 entspricht der Ausführung in FIG 1.

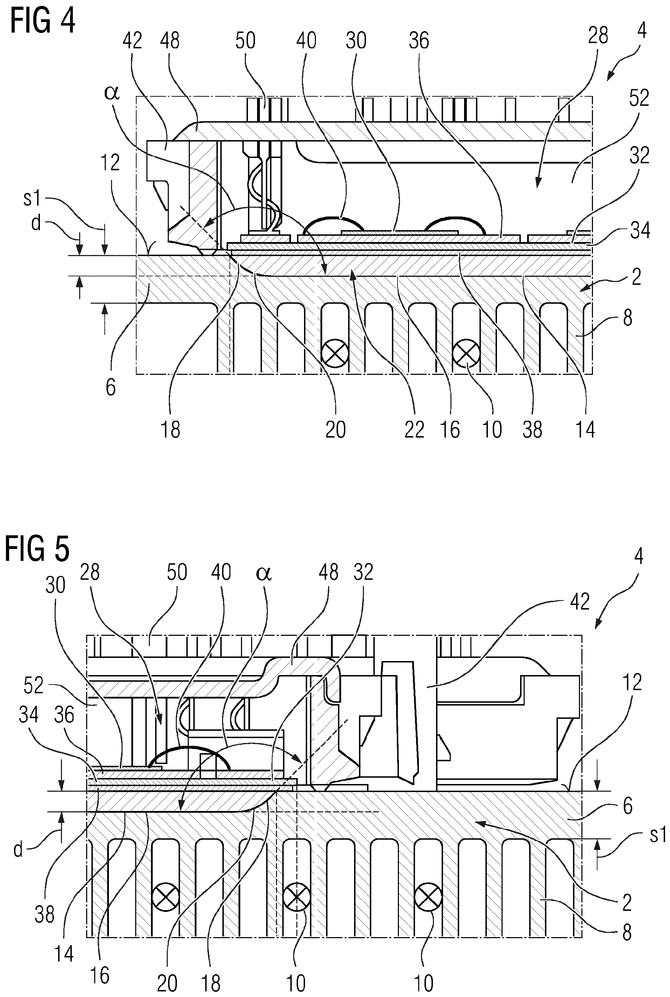

FIG 4 zeigt eine vergrößerte schematische Querschnittsdarstellung einer ersten Ausführungsform eines Halbleitermoduls 4 im Bereich eines stumpfen Winkels α zwischen der Grundfläche 16 und einem Wandabschnitt 18 der Kavität 14. Eine Dicke d der Wärmespreiz-Lage 22 ist größer als die Hälfte der ersten Stärke s1 der Grundplatte 6 des Kühlkörpers 2, wodurch eine sehr gute thermische Anbindung der Halbleiterelemente 30 erreicht wird. Die Wärmespreiz-Lage 22 schließt im Wesentlichen bündig mit dem Substrat 32 ab, wobei der stumpfe Winkels α so ausgeführt ist, dass die Wärmespreiz-Lage 22 unterhalb der Halbleiterelemente 30 ihre maximale Dicke d aufweist. Die weitere Ausführung des Halbleitermoduls 4 in FIG 4 entspricht der Ausführung in FIG 3.

FIG 5 zeigt eine vergrößerte schematische Querschnittsdarstellung einer zweiten Ausführungsform eines Halbleitermoduls 4 im Bereich eines stumpfen Winkels α zwischen der Grundfläche 16 und einem Wandabschnitt 18 der Kavität 14. Eine Dicke d der Wärmespreiz-Lage 22 ist kleiner als die Hälfte der ersten Stärke s1 der Grundplatte 6 des Kühlkörpers 2, wodurch eine ausreichende thermische Anbindung der Halbleiterelemente 30, insbesondere für niedrigere Leistungen, erreicht wird. Das Substrat 32 steht über die Wärmespreiz-Lage 22 über, wobei die Wärmespreiz-Lage 22 unterhalb der Halbleiterelemente 30 ihre maximale Dicke d aufweist. Die weitere Ausführung des Halbleitermoduls 4 in FIG 5 entspricht der Ausführung in FIG 4.

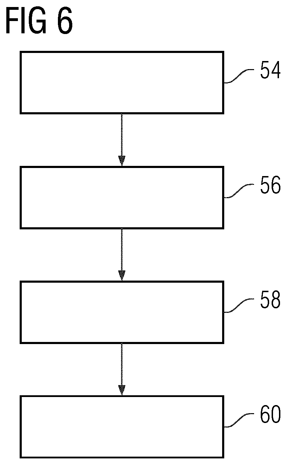

FIG 6 zeigt ein Ablaufdiagramm eines Verfahrens zur Herstellung eines Halbleitermoduls 4, welches in einer der Figuren 3 bis 5 dargestellt ist. Das Verfahren beinhaltet ein Einbringen 54 einer Kavität 14 in eine Kühlkörper-Oberfläche 12 eines Kühlkörpers 2, der aus einem ersten metallischen Werkstoff hergestellt ist. Die Kavität 14 weist eine ebene Grundfläche 16 und mindestens einen Wandabschnitt 18 auf. Beim Einbringen 54 der Kavität 14 wird jeweils ein stumpfer Winkel α zwischen der Grundfläche 16 und dem Wandabschnitten 18 ausgebildet, wobei ein stumpfer Winkel in diesem Zusammenhang zwischen 95° und 175° liegt (95°≤α≤175°). Unter anderem kann die Kavität 14 bei einer rechteckigen oder quadratischen Grundfläche 16 pyramidenstumpfartig oder bei einer elliptischen oder kreisförmigen Grundfläche 16 kegelstupfartig ausgeführt sein.

In einem weiteren Schritt erfolgt ein Aufbringen 56 eines zweiten metallischen Werkstoffs, der eine höhere Wärmeleitfähigkeit als der erste metallische Werkstoff aufweist, in der Kavität 14 mittels eines thermischen Spritzverfahrens zur Ausbildung einer Wärmespreiz-Lage 22. Insbesondere wird der zweite metallische Werkstoff mittels Kaltgasspritzen aufgebracht.

Nach dem Aufbringen 56 des zweiten metallischen Werkstoffs erfolgt optional ein Planfräsen 58 der Kühlkörper-Oberfläche 12, sodass die Wärmespreiz-Lage 22 planbündig mit der Kühlkörper-Oberfläche 12 abschließt.

In einem weiteren Schritt erfolgt ein Verbinden 60 der Halbleiteranordnung 28 mit der Wärmespreiz-Lage 22. Die Halbleiteranordnung 28 weist mindestens ein Halbleiterelement 30 und ein Substrat 32 auf, wobei das Substrat 32 der Halbleiteranordnung 28, insbesondere vollflächig, unmittelbar stoffschlüssig mit der Wärmespreiz-Lage 22 verbunden wird. Die stoffschlüssige Verbindung zum Kühlkörper 2 kann unter anderem durch Löten oder Sintern hergestellt werden.

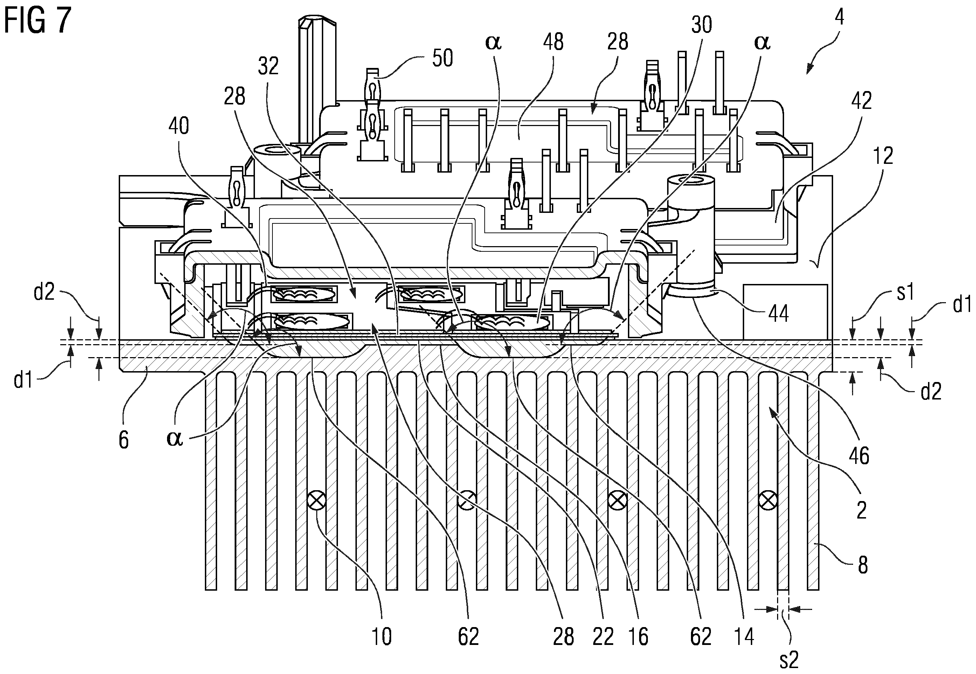

FIG 7 zeigt eine schematische dreidimensionale Schnittdarstellung einer dritten Ausführungsform eines Halbleitermoduls 4 mit beispielhaft zwei Halbleiteranordnungen 28, welche auf einem gemeinsamen Kühlkörper 2 verbunden sind. Die Grundfläche 16 der Kavität 14 weist zusätzliche Vertiefungen 62 auf, welche kleiner sind als die Grundfläche 16 der Kavität 14 und innerhalb einer senkrechten Projektionsfläche der Halbleiterelemente 30 angeordnet sind. Die zusätzlichen Vertiefungen 62 stehen über die Grundfläche der Halbleiterelemente 30 hinaus. Der zweite metallische Werkstoff ist mittels des thermischen Spritzverfahrens in der Kavität 14 und in den zusätzlichen Vertiefungen 62 eingebracht, sodass eine Wärmespreiz-Lage 22 ausgebildet ist, welche unterschiedliche Dicken d1, d2 aufweist, wobei eine zweite Dicke d2 größer als eine erste Dicke d1 ist. Die unterhalb der Halbleiterelemente 30 angeordneten und mit dem zweiten metallischen Werkstoff gefüllten zusätzlichen Vertiefungen 62 sorgen für eine lokale Verdickung der Wärmespreiz-Lage 22, was die thermische Anbindung der Halbleiterelemente 30 verbessert.

Wie die Kavität 14 weisen die zusätzlichen Vertiefungen 62 eine im Wesentlichen ebene rechteckige Grundfläche 16 und Wandabschnitte 18 auf. Zwischen der Grundfläche 16 und dem Wandabschnitten 18 ist ein stumpfer Winkel α ausgebildet, der dem stumpfen Winkel α der Kavität entsprechen oder sich von diesem unterscheiden kann. Durch den stumpfen Winkel α weisen die zusätzlichen Vertiefungen 62 ebenfalls einen im Wesentlichen trapezförmigen Querschnitt auf. Zwischen der Grundfläche 16 und den Wandabschnitten 18 sowie zwischen benachbarten Wandabschnitten 18 der zusätzlichen Vertiefungen 62 sind ebenfalls konkav gewölbte Formoberflächen 20 ausgebildet. Die weitere Ausführung des Halbleitermoduls 4 in FIG 7 entspricht der Ausführung in FIG 3.

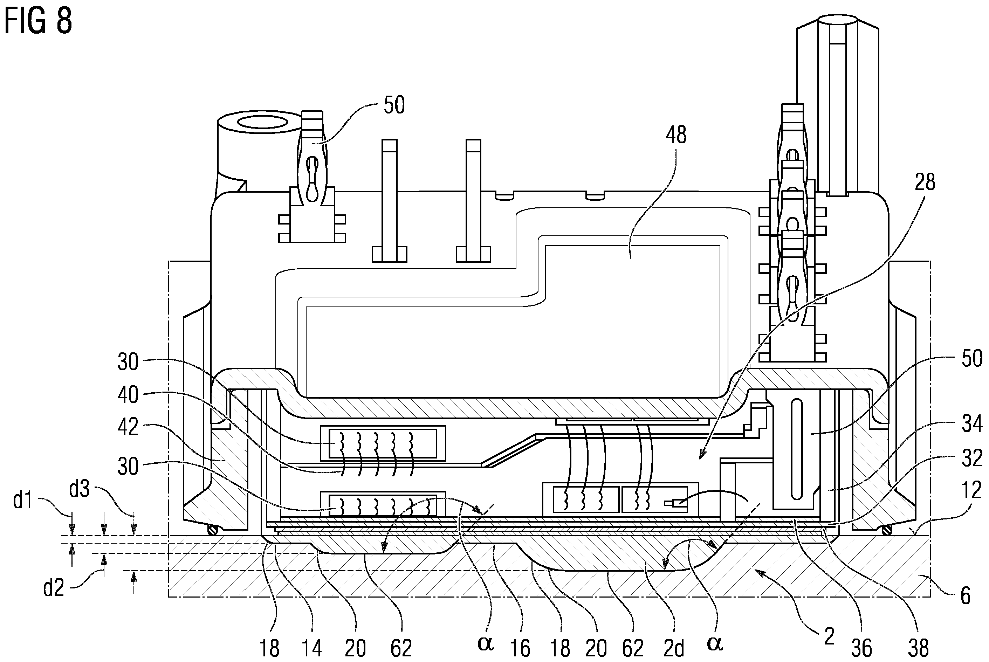

FIG 8 zeigt eine schematische dreidimensionale Schnittdarstellung einer vierten Ausführungsform eines Halbleitermoduls 4. Die Grundfläche 16 der Kavität 14 weist unterschiedliche tiefe zusätzliche Vertiefungen 62 auf, welche innerhalb einer senkrechten Projektionsfläche der Halbleiterelemente 30 angeordnet sind. Durch Füllung der unterschiedliche tiefen zusätzlichen Vertiefungen 62 mit dem zweiten metallischen Werkstoff mittels des thermischen Spritzverfahrens wird eine Wärmespreiz-Lage 22 ausgebildet ist, welche unterschiedliche Dicken d1, d2, d3 aufweist, wobei eine zweite Dicke d2 größer als eine erste Dicke d1 und eine dritte Dicke d3 größer als eine zweite Dicke d2 ist. Durch Variation der Dicke d2, d3 der Wärmespreiz-Lage 22 mittels unterhalb der Halbleiterelemente 30 angeordneten und mit dem zweiten metallischen Werkstoff gefüllten zusätzlichen Vertiefungen 62 kann eine thermische Anbindung an eine während des Betriebes auftretende Verlustwärme der Halbleiterelemente 30 angepasst werden. Beispielsweise weist die Wärmespreiz-Lage 22 unter einem IGBT aufgrund der größeren abzuführenden Abwärme eine größere Dicke d2, d3 auf als unter einer Diode. Die weitere Ausführung des Halbleitermoduls 4 in FIG 8 entspricht der Ausführung in FIG 7.

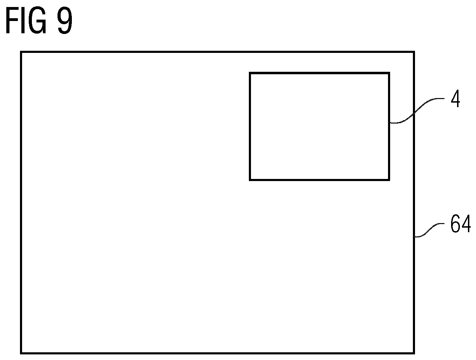

FIG 9 zeigt eine schematische Darstellung eines Stromrichters 64 mit einem Halbleitermodul 4. Der Stromrichter 64 kann mehr als ein Halbleitermodul 4 umfassen.

Zusammenfassend betrifft die Erfindung ein Verfahren zur Herstellung eines Halbleitermoduls 4 mit mindestens einer Halbleiteranordnung 28 und einem Kühlkörper 2 umfassend folgende Schritte: Bereitstellen eines Kühlkörpers 2, der aus einem ersten metallischen Werkstoff hergestellt ist, Einbringen 54 einer Kavität 14 in eine Kühlkörper-Oberfläche 12, wobei die Kavität 14 eine, insbesondere parallel zur Kühlkörper-Oberfläche 12 verlaufende, Grundfläche 16 und zumindest einen Wandabschnitt 18 aufweist, Aufbringen 56 eines zweiten metallischen Werkstoffs, der eine höhere Wärmeleitfähigkeit als der erste metallische Werkstoff aufweist, in der Kavität 14 mittels eines thermischen Spritzverfahrens zur Ausbildung einer Wärmespreiz-Lage 22,Verbinden 60 der Halbleiteranordnung 28 mit der Wärmespreiz-Lage 22. Um eine thermische Kontaktierung des zweiten metallischen Werkstoffs in der Kavität 14 zu verbessern, wird vorgeschlagen, dass beim Einbringen 54 der Kavität 14 jeweils ein stumpfer Winkel α zwischen der Grundfläche 16 und dem zumindest einen Wandabschnitt 18 ausgebildet wird.

## Patentansprüche

1. Verfahren zur Herstellung eines Halbleitermoduls (4) mit mindestens einer Halbleiteranordnung (28) und einem Kühlkörper (2) umfassend folgende Schritte:
- Bereitstellen eines Kühlkörpers (2), der aus einem ersten metallischen Werkstoff hergestellt ist,
- Einbringen (54) einer Kavität (14) in eine Kühlkörper-Oberfläche (12),
wobei die Kavität (14) eine, insbesondere parallel zur Kühlkörper-Oberfläche (12) verlaufende, Grundfläche (16) und zumindest einen Wandabschnitt (18) aufweist,
- Aufbringen (56) eines zweiten metallischen Werkstoffs, der eine höhere Wärmeleitfähigkeit als der erste metallische Werkstoff aufweist, in der Kavität (14) mittels eines thermischen Spritzverfahrens zur Ausbildung einer Wärmespreiz-Lage (22),
- Verbinden (60) der Halbleiteranordnung (28) mit der Wärmespreiz-Lage (22),
wobei beim Einbringen (54) der Kavität (14) jeweils ein stumpfer Winkel (α) zwischen der Grundfläche (16) und dem zumindest einen Wandabschnitt (18) ausgebildet wird,
**dadurch gekennzeichnet, dass**
in die Grundfläche (16) der Kavität (14) zumindest eine zusätzliche Vertiefung (62) eingebracht wird,
welche kleiner als die Grundfläche (16) der Kavität (14) ist, wobei das Aufbringen (56) des zweiten metallischen Werkstoffs mittels des thermischen Spritzverfahrens in der Kavität (14) und der zumindest einen zusätzlichen Vertiefung (62) erfolgt, sodass eine Wärmespreiz-Lage (22) ausgebildet wird, welche unterschiedliche Dicken (d1, d2, d3) aufweist.

2. Verfahren nach Anspruch 1,
wobei das Aufbringen (56) des zweiten metallischen Werkstoffs unter einem Spritzwinkel (β) des thermischen Spritzverfahrens im Bereich von 60° bis 90°, insbesondere von 70° bis 90°, erfolgt.

3. Verfahren nach einem der Ansprüche 1 oder **2,**
wobei nach dem Aufbringen (56) des zweiten metallischen Werkstoffs ein Planfräsen (58) der Kühlkörper-Oberfläche (12) erfolgt.

4. Verfahren nach einem der vorherigen Ansprüche,
wobei beim Einbringen (54) der Kavität (14) zwischen der Grundfläche (16) und zumindest einem Wandabschnitt (18) und/oder zwischen zumindest zwei Wandabschnitten (18) eine konkav gewölbte Formoberfläche (20) ausgebildet wird.

5. Verfahren nach einem der vorherigen Ansprüche,
wobei die Halbleiteranordnung (28) mindestens ein Halbleiterelement (30) und ein Substrat (32) umfasst,
wobei das Substrat (32) der Halbleiteranordnung (28) flächig mit der Wärmespreiz-Lage (22) verbunden wird.

6. Verfahren nach Anspruch 5,
wobei das Substrat (32) der Halbleiteranordnung (28) unmittelbar stoffschlüssig mit der Wärmespreiz-Lage (22) verbunden wird.

7. Verfahren nach einem der Ansprüche 5 oder 6,
wobei eine Oberfläche der Wärmespreiz-Lage (22) im Wesentlichen einer Fläche des Substrats (32) entspricht,
wobei das Substrat (32) der Halbleiteranordnung (28) vollflächig mit der Wärmespreiz-Lage (22) verbunden wird.

8. Verfahren nach einem der Ansprüche 5 bis 7,
wobei die zumindest eine zusätzliche Vertiefung (62) innerhalb einer senkrechten Projektionsfläche mindestens eines Halbleiterelements (30) angeordnet wird.

9. Halbleitermodul (4) mit mindestens einer Halbleiteranordnung (28) und einem Kühlkörper (2),
welcher aus einem ersten metallischen Werkstoff hergestellt ist und mindestens eine Kavität (14) umfasst, die eine, insbesondere parallel zur Kühlkörper-Oberfläche (12) verlaufende, Grundfläche (16) und zumindest einen Wandabschnitt (18) aufweist,
wobei in der Kavität (14) ein zweiter metallischer Werkstoff, der eine höhere Wärmeleitfähigkeit als der erste metallische Werkstoff aufweist, mittels eines thermischen Spritzverfahrens zur Ausbildung einer Wärmespreiz-Lage (22) aufgebracht ist,
wobei die Halbleiteranordnung (28) mit der Wärmespreiz-Lage (22) verbunden ist,
wobei ein stumpfer Winkel (α) zwischen der Grundfläche (16) und dem zumindest einen Wandabschnitt (18) ausgebildet ist, **dadurch gekennzeichnet, dass**
in die Grundfläche (16) der Kavität (14) zumindest eine zusätzliche Vertiefung (62) aufweist,
welche kleiner ist als die Grundfläche (16) der Kavität (14) ist,
wobei der zweite metallische Werkstoff mittels des thermischen Spritzverfahrens in der Kavität (14) und der zumindest einen zusätzlichen Vertiefung (62) eingebracht ist,
sodass eine Wärmespreiz-Lage (22) ausgebildet ist, welche unterschiedliche Dicken (d1, d2, d3) aufweist.

10. Halbleitermodul (4) nach Anspruch 9,
wobei der stumpfe Winkel (α) zwischen der Grundfläche (16) und dem zumindest einen Wandabschnitt (18) im Bereich von 95° bis 150°, insbesondere 110° bis 150°, ferner insbesondere 130° bis 150°, liegt.

11. Halbleitermodul (4) nach einem der Ansprüche 9 oder 10, wobei der zweite metallische Werkstoff (42) stoffschlüssig mit dem ersten metallischen Werkstoff verbunden ist und im Wesentlichen planbündig mit der Kühlkörper-Oberfläche (12) abschließt.

12. Halbleitermodul (4) nach einem der Ansprüche 9 bis 11,
wobei zwischen der Grundfläche (16) und zumindest einem Wandabschnitt (18) und/oder zwischen zumindest zwei Wandabschnitten (18) eine konkav gewölbte Formoberfläche (20) ausgebildet ist.

13. Halbleitermodul (4) nach einem der Ansprüche 9 bis 12,
wobei die Halbleiteranordnung (28) mindestens ein Halbleiterelement (30) und ein Substrat (32) umfasst,
wobei das Substrat (32) der Halbleiteranordnung (28) flächig mit der Wärmespreiz-Lage (22) verbunden ist.

14. Halbleitermodul (4) nach Anspruch 13,
wobei das Substrat (32) der Halbleiteranordnung (28) unmittelbar stoffschlüssig mit der Wärmespreiz-Lage (22) verbunden ist.

15. Halbleitermodul (4) nach einem der Ansprüche 13 oder 14,
wobei das Substrat (32) der Halbleiteranordnung (28) vollflächig, mit der Wärmespreiz-Lage (22) verbunden ist und
wobei die Wärmespreiz-Lage (22) im Wesentlichen bündig mit dem Substrat (32) abschließt.

16. Halbleitermodul (4) nach einem der Ansprüche 13 bis 15, wobei die zumindest eine zusätzliche Vertiefung (62) innerhalb einer senkrechten Projektionsfläche mindestens eines Halbleiterelements (30) angeordnet ist.

17. Stromrichter (64) mit mindestens einem Halbleitermodul (4) nach einem der Ansprüche 9 bis 16.

18. Computerprogrammprodukt, umfassend Befehle, die bei einer Ausführung des Programms durch einen Computer diesen veranlassen, ein, insbesondere thermisches und/oder elektrisches, Verhalten des Halbleitermoduls (4) nach einem der Ansprüche 9 bis 16 zu simulieren.

## Claims

1. Method for producing a semiconductor module (4) having at least one semiconductor arrangement (28) and a heatsink (2) comprising the following steps:
- providing a heatsink (2) which is produced from a first metal material,
- introducing (54) a cavity (14) into a heatsink surface (12), wherein the cavity (14) has a base surface (16) which in particular extends in parallel with the heatsink surface (12), and at least one wall portion (18),
- applying (56) a second metal material, which has a higher thermal conductivity than the first metal material, in the cavity (14) using a thermal spraying method to form a heat-spreading layer (22),
- connecting (60) the semiconductor arrangement (28) to the heat-spreading layer (22),
wherein when introducing (54) the cavity (14) an obtuse angle (α) is in each case formed between the base surface (16) and the at least one wall portion (18),
**characterised in that**
at least one additional depression (62) is introduced into the base surface (16) of the cavity (14),
which is smaller than the base surface (16) of the cavity (14),
wherein the application (56) of the second metal material is carried out using the thermal spraying method in the cavity (14) and the at least one additional depression (62),
so that a heat-spreading layer (22) is formed, which has different thicknesses (d1, d2, d3).

2. Method according to claim 1,
wherein the application (56) of the second metal material is carried out at a spray angle (β) of the thermal spraying method in the range of between 60° and 90°, in particular 70° and 90°.

3. Method according to one of claims 1 or 2,
wherein after applying (56) the second metal material a facemilling (58) of the heatsink surface (12) is carried out.

4. Method according to one of the preceding claims,
wherein when introducing (54) the cavity (14) between the base surface (16) and at least one wall portion (18) and/or between at least two wall portions (18) a concave curved mould surface (20) is formed.

5. Method according to one of the preceding claims,
wherein the semiconductor arrangement (28) comprises at least one semiconductor element (30) and a substrate (32),
wherein the substrate (32) of the semiconductor arrangement (28) is connected flush with the heat-spreading layer (22).

6. Method according to claim 5,
wherein the substrate (32) of the semiconductor arrangement (28) is directly connected in a material-bonded manner to the heat-spreading layer (22).

7. Method according to one of claims 5 or 6,
wherein a surface of the heat-spreading layer (22) substantially corresponds to a surface of the substrate (32),
wherein the substrate (32) of the semiconductor arrangement (28) is connected over the whole surface to the heat-spreading layer (22).

8. Method according to one of claims 5 to 7,
wherein the at least one additional depression (62) is arranged inside a perpendicular projection surface of at least one semiconductor element (30).

9. Semiconductor module (4) having at least one semiconductor arrangement (28) and a heatsink (2) which is produced from a first metal material and comprises at least one cavity (14), which has a base surface (16) which in particular extends in parallel with the heatsink surface (12), and at least one wall portion (18),
wherein a second metal material, which has a higher thermal conductivity than the first metal material, is applied in the cavity (14) using a thermal spraying method to form a heat-spreading layer (22),
wherein the semiconductor arrangement (28) is connected to the heat-spreading layer (22),
wherein an obtuse angle (α) is formed between the base surface (16) and the at least one wall portion (18),
**characterised in that**
the base surface (16) of the cavity (14) has at least one additional depression (62),
which is smaller than the base surface (16) of the cavity (14),
wherein the second metal material is introduced in the cavity (14) and the at least one additional depression (62) using the thermal spraying method,
so that a heat-spreading layer (22) is formed which has different thicknesses (d1, d2, d3).

10. Semiconductor module (4) according to claim 9,
wherein the obtuse angle (α) between the base surface (16) and the at least one wall portion (18) is in the range of between 95° and 150°, in particular 110° and 150°, further in particular 130° and 150°.

11. Semiconductor module (4) according to one of claims 9 or 10,
wherein the second metal material (42) is connected in a material-bonded manner to the first metal material and is substantially flush with the heatsink surface (12).

12. Semiconductor module (4) according to one of claims 9 to 11,
wherein a concave curved mould surface (20) is formed between the base surface (16) and at least one wall portion (18) and/or between at least two wall portions (18).

13. Semiconductor module (4) according to one of claims 9 to 12,
wherein the semiconductor arrangement (28) comprises at least one semiconductor element (30) and a substrate (32),
wherein the substrate (32) of the semiconductor arrangement (28) is connected flush with the heat-spreading layer (22).

14. Semiconductor module (4) according to claim 13,
wherein the substrate (32) of the semiconductor arrangement (28) is directly connected in a material-bonded manner to the heat-spreading layer (22).

15. Semiconductor module (4) according to one of claims 13 or 14,
wherein the substrate (32) of the semiconductor arrangement (28) is connected over the whole surface to the heat-spreading layer (22) and
wherein the heat-spreading layer (22) is substantially flush with the substrate (32).

16. Semiconductor module (4) according to one of claims 13 to 15,
wherein the at least one additional depression (62) is arranged inside a perpendicular projection surface of at least one semiconductor element (30).

17. Power converter (64) having at least one semiconductor module (4) according to one of claims 9 to 16.

18. Computer program product, comprising commands, which when the program is executed by a computer cause said computer to simulate an, in particular thermal and/or electrical, behaviour of the semiconductor module (4) according to one of claims 9 to 16.

## Revendications

1. Procédé de fabrication d'un module (4) de semiconducteur comprenant au moins un agencement (28) de semiconducteur et un dissipateur (2) de chaleur comprenant les stades suivants :
- se procurer un dissipateur (2) de chaleur, qui est en un matériau métallique,
- ménager (54) une cavité (14) dans une surface (12) du dissipateur de chaleur,
- dans lequel la cavité (14) a une surface (16) de base s'étendant, en particulier parallèlement à la surface (12) du dissipateur de chaleur et au moins une partie (18) de paroi,
- déposer (56) dans la cavité (14) un deuxième matériau métallique, qui a une conductibilité de la chaleur plus grande que le premier matériau métallique, au moyen d'un procédé de projection thermique pour la constitution d'une couche (22) de projection thermique,
- relier (60) l'agencement (28) de semiconducteur à la couche (22) de projection thermique,
dans lequel, lorsque l'on ménage (54) la cavité (14), on constitue respectivement un angle (α) obtus entre la surface (16) de base et la au moins une partie (18) de paroi,
**caractérisé en ce que** l'
on ménage dans la surface (16) de base de la cavité (14) au moins un évidement (62) supplémentaire,
qui est plus petit que la surface (16) de base de la cavité (14), dans lequel le dépôt (56) du deuxième matériau métallique au moyen du procédé de projection thermique s'effectue dans la cavité (14) et dans le au moins un évidement (62) supplémentaire, de manière à constituer une couche (22) de projection thermique, qui a des épaisseurs (d1, d2, d3) différentes.

2. Procédé suivant la revendication 1,
dans lequel le dépôt (56) du deuxième matériau métallique s'effectue sous un angle (β) de projection du procédé de projection thermique dans la plage de 60° à 90°, en particulier de 70° à 90°.

3. Procédé suivant l'une des revendications 1 ou 2,
dans lequel, après le dépôt (56) du deuxième matériau métallique, a lieu un fraisage (58) plan de la surface (12) du dissipateur de chaleur.

4. Procédé suivant l'une des revendications précédentes,
dans lequel, lorsque l'on ménage (54) la cavité (14), on forme une surface (20) de forme incurvée de manière concave entre la surface (16) de base et au moins l'une des parties (18) de paroi et/ou au moins deux parties (18) de paroi.

5. Procédé suivant l'une des revendications précédentes,
dans lequel l'agencement (28) de semiconducteur comprend au moins un élément (30) à semiconducteur et un substrat (32),
dans lequel le substrat (32) de l'agencement (28) de semiconducteur est relié par surface à la couche (22) de projection thermique.

6. Procédé suivant la revendication 5,
dans lequel le substrat (32) de l'agencement (28) de semiconducteur est relié directement à coopération de matière à la couche (22) de projection thermique.

7. Procédé suivant l'une des revendications 5 ou 6,
dans lequel une surface de la couche (22) de projection thermique correspond sensiblement à une surface du substrat (32),
dans lequel le substrat (32) de l'agencement (28) de semiconducteur est relié sur toute la surface à la couche (22) de projection thermique.

8. Procédé suivant l'une des revendications 5 à 7,
dans lequel le au moins un évidement (62) supplémentaire est disposé à l'intérieur d'une surface de projection verticale au moins d'un élément (30) à semiconducteur.

9. Module (4) de semiconducteur comprenant au moins un agencement (28) de semiconducteur et un dissipateur (2) de chaleur, qui est en un premier matériau métallique et qui comprend au moins une cavité (14), qui a une surface (16) de base s'étendant, en particulier parallèlement à la surface (12) du dissipateur de chaleur, et au moins une partie (18) de paroi,
dans lequel il est déposé dans la cavité (14) pour la constitution d'une couche (22) de projection thermique, au moyen d'un procédé de projection thermique, un deuxième matériau métallique, qui a une conductibilité à la chaleur plus grande que le premier matériau métallique,
dans lequel l'agencement (28) de semiconducteur est relié à la couche (22) de projection thermique,
dans lequel un angle (α) obtus est constitué entre la surface (16) de base et la au moins une partie (18) de paroi,
**caractérisé en ce que**
dans la surface (16) de base, la cavité (14) a au moins un évidement (62) supplémentaire,
qui est plus petit que la surface (16) de base de la cavité (14), dans lequel le deuxième matériau métallique est, au moyen du procédé de projection thermique, introduit dans la cavité (14) et dans le au moins un évidement (62) supplémentaire,
de manière à constituer une couche (22) de projection thermique, qui a des épaisseurs (d1, d2, d3) différentes.

10. Module (4) de semiconducteur suivant la revendication 9,
dans lequel l'angle (α) obtus entre la surface (16) de base et la au moins une partie (18) de paroi est dans la plage de 95° à 150°, en particulier de 110° à 150°, en outre en particulier de 130° à 150°.

11. Module (4) de semiconducteur suivant l'une des revendications 9 ou 10,
dans lequel le deuxième matériau (42) métallique est relié à coopération de matière au premier matériau métallique et est sensiblement à affleurement suivant un plan avec la surface (12) du dissipateur de chaleur.

12. Module (4) de semiconducteur suivant l'une des revendications 9 à 11,
dans lequel il est constitué une surface (20) de forme incurvée de manière concave entre la surface (16) de base et au moins l'une des parties (18) de paroi et/ou au moins deux parties (18) de paroi.

13. Module (4) de semiconducteur suivant l'une des revendications 9 à 12,
dans lequel l'agencement (28) de semiconducteur comprend au moins un élément (30) à semiconducteur et un substrat (32),
dans lequel le substrat (32) de l'agencement (28) de semiconducteur est relié par surface à la couche (22) de projection thermique.

14. Module (4) de semiconducteur suivant la revendication 13,
dans lequel le substrat (32) de l'agencement (28) de semiconducteur est relié directement à coopération de matière à la couche (22) de projection thermique.

15. Module (4) de semiconducteur suivant l'une des revendications 13 ou 14,
dans lequel une surface de la couche (22) de projection thermique correspond sensiblement à une surface du substrat (32),
dans lequel le substrat (32) de l'agencement (28) de semiconducteur est relié sur toute la surface à la couche (22) de projection thermique.

16. Module (4) de semiconducteur suivant l'une des revendications 13 à 15,
dans lequel le au moins un évidement (62) supplémentaire est disposé à l'intérieur d'une surface de projection verticale au moins d'un élément (30) à semiconducteur.

17. Convertisseur (64) comprenant au moins un module (4) de semiconducteur suivant l'une des revendications 9 à 16.

18. Produit de programme d'ordinateur, comprenant des instructions, qui, lors de l'exécution du programme par ordinateur, font que celui-ci simule un comportement, en particulier thermique et/ou électrique, du module (4) de semiconducteur suivant l'une des revendications 9 à 16.
